(19) Europäisches Patentamt

European Patent Office

Office européen des brevets

(11) Veröffentlichungsnummer: **0 202 684 B1**

(12) **EUROPÄISCHE PATENTSCHRIFT**

(45) Veröffentlichungstag der Patentschrift: **11.03.92**

(21) Anmeldenummer: **86107024.1**

(22) Anmeldetag: **23.05.86**

(51) Int. Cl.⁵: **H03M 7/22**, H03K 19/173

(54) **Verfahren zum selektiven Ansteuern von elektrischen Schaltkreisen sowie Schaltungsanordnung zur Durchführung des Verfahrens.**

(30) Priorität: **24.05.85 DE 3518827**

(43) Veröffentlichungstag der Anmeldung:
**26.11.86 Patentblatt 86/48**

(45) Bekanntmachung des Hinweises auf die
Patenterteilung:
**11.03.92 Patentblatt 92/11**

(84) Benannte Vertragsstaaten:
**DE FR GB IT**

(56) Entgegenhaltungen:
**DE-A- 3 208 394**
**US-A- 4 115 706**
**US-A- 4 148 099**

(73) Patentinhaber: **Wilhelm Ruf KG**
**Schwanthaler Strasse 18**
**W-8000 München 2(DE)**

(72) Erfinder: **Keller, Herbert**
**Mühlenstrasse 17**
**W-8212 Übersee(DE)**

(74) Vertreter: **von Bülow, Tam, Dipl.-Ing.,**
**Dipl.-Wirtsch.-Ing. et al**
**SAMSON & BÜLOW Widenmayerstrasse 5**
**W-8000 München 22(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 202 684 B1

**Beschreibung**

Die Erfindung bezieht sich auf ein Verfahren zum selektiven Ansteuern von elektrischen Schaltkreisen gemäß dem Oberbegriff des Patentanspruches 1 sowie auf eine Schaltungsanordnung zur Durchführung des Verfahrens gemäß dem Oberbegriff des Patentanspruches 7.

Verfahren und Vorrichtung dieser Art sind aus der DE 32 08 394 A1 bekannt. Dort soll durch Betätigen eines Auslenkhebels ein Ventilmagnet aus einer Gruppe von mehreren Ventilmagneten ausgewählt und angesteuert werden. Der Auslenkhebel kann in vier verschiedenen Richtungen ausgelenkt werden, wodurch einer von vier Schaltern geschlossen wird. Eine Codiereinrichtung mit vier Eingängen erzeugt ein codiertes Signal, das den anzusteuernden Ventilmagneten bezeichnet. Dieses im BCD-Code codierte Signal wird über eine Übertragungsstrecke zu einer Decodiereinrichtung geleitet und dort decodiert, dergestalt, daß auf einer von vier Leitungen, die jeweils einem Ventilmagneten zugeordnet sind, ein Aktivierungssignal erscheint. Dieses Signal öffnet eine dem jeweiligen Ventilmagnet zugeordnete Torschaltung, die dann Nutzsignale in Form von Impulsen aus einem Signalgenerator zu dem ausgewählten Ventilmagnet durchläßt. Das Tastverhältnis dieser Impulse kann über den Auslenkhebel stufenlos eingestellt werden. Betrachtet man die Decodiereinrichtung als den Eingang eines anzusteuernden Schaltkreises mit einer Anzahl n von Ansteueranschlüssen, so kann die Schaltungsanordnung eine Anzahl von $2^n$ einzeln auswählbaren Komponenten (hier: Ventilmagnete) haben. Bei hochintegrierten Schaltkreisen erreicht man heute eine derart hohe Packungsdichte, daß es problematisch wird, das Schaltkreisgehäuse noch mit der benötigten Anzahl von "Anschlußbeinchen" zu versehen.

So werden beispielsweise heute integrierte Schaltkreise verwendet, die (intern) eine Vielzahl von unterschiedlichen Funktionsgruppen aufweisen, von denen im normalen Betrieb jedoch nur ausgewählte aktiv sein sollen. Durch eine externe Beschaltung einzelner "Anschlußbeinchen" wird heute die gewünschte Funktionsgruppe aktiviert. Diese externe Beschaltung kann durch eine feste Verdrahtung realisiert sein, mit der bestimmte Anschlüsse auf bestimmte Potentiale (logisch 0 oder logisch 1) gelegt werden. Auch ist es möglich, statt einer festen Verdrahtung mechanische oder elektrische Schalter zu verwenden.

Aus der DE 32 08 394 A1 läßt sich das Prinzip übertragen, daß man eine Reduzierung der benötigen "Anschlußbeinchen" dadurch erhält, daß die Ansteueranschlüsse für die Auswahl bestimmter Baugruppen mit codierten Signalen beaufschlagt werden, beispielsweise im Binärcode, wobei der integrierte Schaltkreis dann intern einen Decodierer aufweist. Damit kann man mit einer Anzahl n Anschlußbeinchen $2^n$ Auswahlmöglichkeiten realisieren.

Aufgabe der Erfindung ist es, Verfahren und Schaltungsanordnung der eingangs genannten Art dahingehend zu verbessern, dass bei gleicher Anzahl von Ansteueranschlüssen eine grössere Anzahl von Auswahlmöglichkeiten geschaffen wird oder umgekehrt bei gleicher Anzahl von Auswahlmöglichkeiten eine geringere Anzahl von Ansteueranschlüssen benötigt wird.

Diese Aufgabe wird durch die im kennzeichnenden Teil der Patentansprüche 1 bzw. 7 angegebenen Merkmale gelöst. Vorteilhafte Ausgestaltungen und Weiterbildungen der Erfindung sind den Unteransprüchen zu entnehmen.

Im folgenden wird die Erfindung anhand von Ausführungsbeispielen im Zusammenhang mit der Zeichnung ausführlicher erläutert. Es zeigt:

Fig. 1 ein Blockschaltbild einer Schaltungsanordnung nach der Erfindung;

Fig. 2 eine Auswahltabelle der mit der Schaltungsanordnung nach Fig. 1 realisierbaren Schaltungszustände;

Fig. 3 ein detailierteres Blockschaltbild der Schaltungsanordnung nach der Erfindung;

Fig. 4 ein Blockschaltbild ähnlich Fig. 3 jedoch in anderer Darstellungsweise zur Verdeutlichung der innerhalb und ausserhalb des integrierten Schaltkreises angeordneten Baugruppen; und

Fig. 5 ein Blockschaltbild ähnlich Fig. 4 gemäss einer Variante der Erfindung.

Gleiche Bezugszeichen in den einzelnen Figuren bezeichnen gleiche bzw. einander entsprechende Teile.

Alle Ausführungsbeispiele beziehen sich auf eine Schaltungsanordnung mit n = 3 Ansteueranschlüssen, mit der $3^n$ = 27 Auswahlmöglichkeiten realisierbar sind. Selbstverständlich kann die Anzahl n beliebig gewählt werden.

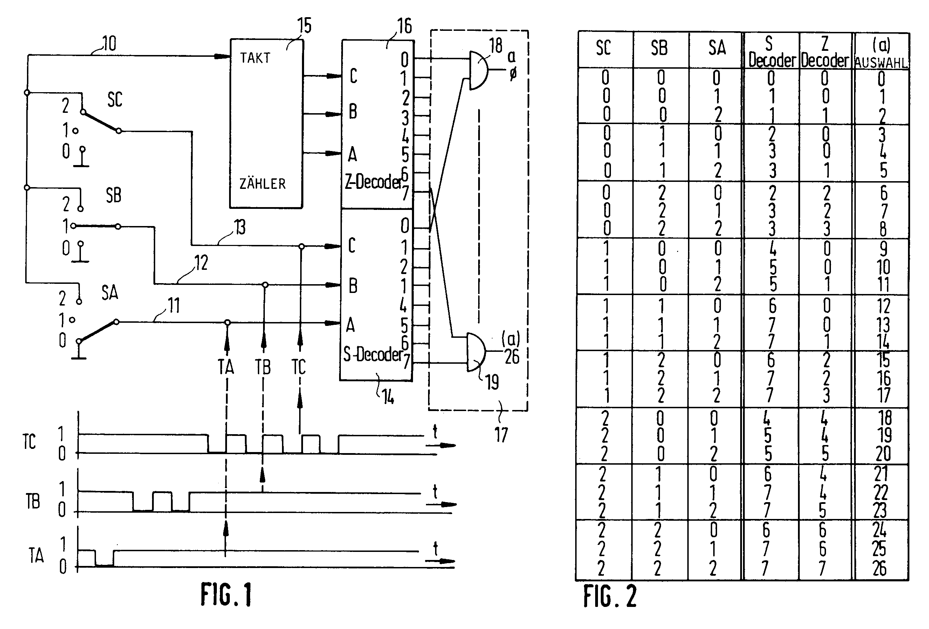

In Fig. 1 sind drei Schalter SA, SB und SC vorgesehen, die jeweils drei verschiedene Schaltstellungen einnehmen können, die mit 0, 1 bzw. 2 bezeichnet sind. Alle mit 0 bezeichneten Anschlüsse liegen auf Masse; alle mit 1 bezeichneten Anschlüsse sind potentialfrei; alle mit 2 bezeichneten Anschlüsse sind mit einer gemeinsamen Sammelleitung 10 verbunden, auf die weiter unten eingegangen wird.

Die mit dem Schaltarm der Schalter SA, SB bzw. SC verbundenen Anschlüsse der Schalter sind mit Ansteuerleitungen bzw. Ansteneranschlüssen 11, 12 bzw. 13 des anzusteuernden integrierten Schaltkreises

EP 0 202 684 B1

verbunden. Weiterhin sind diese Ansteueranschlüsse bzw. -leitungen 11, 12 und 13 jeweils mit einem Eingang A, B bzw. C eines ersten Decoders 14 verbunden, der drei (bzw. allgemein n) Eingänge und acht (bwz. allgemein $2^n$) Ausgänge aufweist, die hier die Ziffern 0 bis 7 tragen. Dieser Decoder 14 decodiert die in einem Binärcode vorliegenden, von den Schaltern SA, SB bzw. SC ankommenden Signale zu einem einzigen Ausgangssignal auf einer der Ausgangsleitungen. Somit fragt dieser Decodierer 14 parallel die Zustände der Schalter ab.

Er wird daher in der Zeichnung als "S-Decoder" bezeichnet, wobei "S" für "Schalter" steht.

Weiterhin können auf die Anschlüsse 11, 12 und 13 Impulse TA, TB bzw. TC gemäss den im unteren Teil der Fig. 1 abgebildeten Impulszügen gegeben werden. Hierbei werden zeitlich gestaffelt den einzelnen Anschlüssen 11, 12 bzw. 13 unterschiedliche Anzahlen von negativen Impulsen zugeführt, wobei im dargestellten Ausführungsbeispiel dem Anschluss 11 ein Impuls, dem Anschluss 12 zwei Impulse und dem Anschluss 13 vier Impulse zugeführt werden.

Will man Mehrdeutigkeiten vermeiden, so ist es bei einem eineindeutigen Code zweckmässig, die Anzahl der Impulse, die den einzelnen Anschlüssen zugeführt werden, gleich dem Gewicht der Bitstellen des entsprechenden Codes zu machen. Allgemein wird also die n-te Leitung $2^n$ Impulse führen. Diese Impulse stammen aus Impulsgeneratoren, die weiter unten erläutert werden. Wichtig ist, dass die Impulse für die einzelnen Anschlüsse zeitlich zueinander versetzt sind, sich also nicht überlappen. Im dargestellten Ausführungsbeispiel werden "negative" Impulse verwendet, was bedeutet, dass der Ruhezustand eine logische 1 bzw. hohes Potential führt, während ein einzelner Impuls durch den logischen Zustand "0" bzw. durch niedriges Potential gekennzeichnet ist. Diese Impulse gelangen nun über die Anschlüsse bzw. Leitungen 11, 12 und 13 und die Schalter SA, SB bzw. SC - je nach Schaltzustand der Schalter - auf die Sammelleitung 10 und zwar nur dann, wenn der zugeordnete Schalter in der mit "2" bezeichneten Stellung steht. Im Ausführungsbeispiel der Fig. 1 ist dies der Schalter SC, so dass vier Impulse (TC) auf die Leitung 10 gelangen. Die Leitung 10 ist an einen Zähleingang eines Zählers 15 angeschlossen, der im konkreten Ausführungsbeispiel ein Binärzähler ist. Dementsprechend hat der Zähler 15 n = 3 Ausgänge, die mit drei Eingängen A, B und C eines zweiten Decoders 16 verbunden sind. Dieser Decoder decodiert die Zählerausgänge; in der Zeichnung wird er daher als Z-Decoder bezeichnet, wobei "Z" für "Zähler" steht. Dieser Decoder entspricht von seinem Aufbau und seiner Funktion her dem ersten Decoder 14.

Bei allen möglichen Stellungen der Schalter SA, SB und SC führen die beiden Decoder 14 und 16 an jeweils nur einem ihrer jeweils acht Ausgängen eine logische "1". Da gewisse Paarungen logischer len an den Ausgängen der beiden Decoder 14 und 16 nicht auftreten können, ergeben sich insgesamt $3^n$ = 27 mögliche Paarungen von logischen len. (So kann beispielsweise folgende Paarung von logischen len nicht auftreten: erster Decoder 14 = 1 und zweiter Decoder 16 = 7. Damit der zweite Decoder 16 im Zustand "7" ist, müssten alle drei Schalter SA, SB und SC in der schaltstellung "2" sein; damit würde aber auch der erste Decoder 14 den Zustand "7" haben usw. Allgemein kann beim Ausführungsbeispiel der Fig. 1 die Dezimalzahl der vom zweiten Decoder 16 decodierten Zahl nur kleiner oder gleich der entsprechenden Zahl des ersten Decoders sein, dagegen nie grösser.)

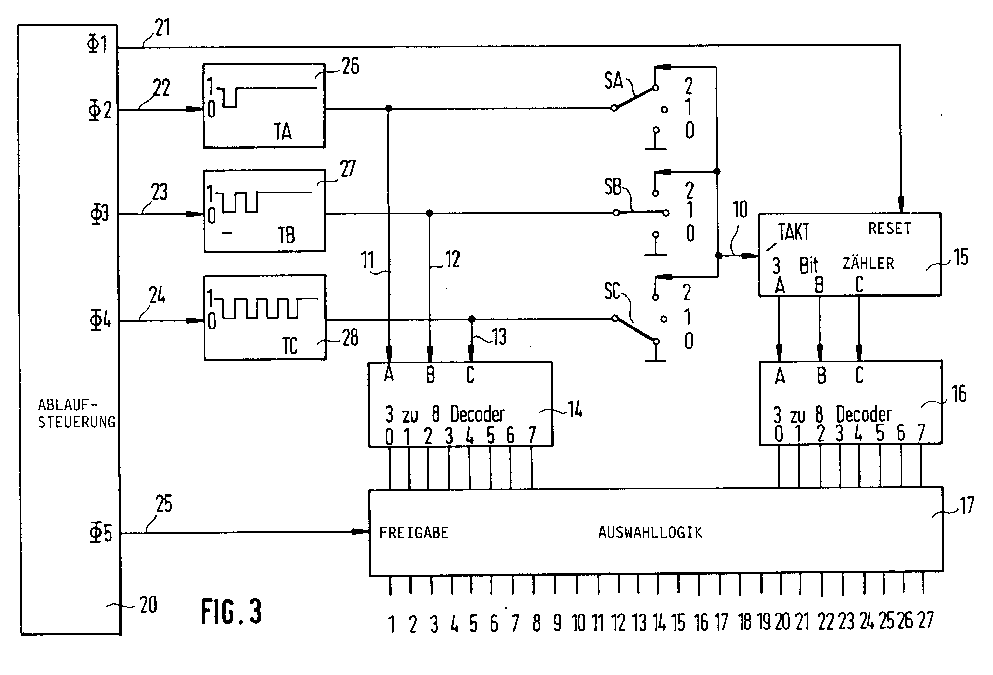

Entsprechend den möglichen Kombinationen gemäss der Tabelle der Fig. 2 sind nun die $2^n$ Ausgänge der beiden Decoder 14 und 16 in einer Auswahllogik 17 verknüpft, die hier durch 27 UND-Gatter 18, 19 realisiert ist. Die Auswahllogik 17 hat also 27 Ausgänge, die mit a0 bis a26 bezeichnet sind. Je nach Schalterstellung der Schalter SA, SB und SC führt also ein einziger dieser Ausgänge eine logische 1, womit dann eine bestimmte Baugruppe oder Funktion des integrierten Schaltkreises ausgewählt werden kann.

Die in Fig. 2 dargestellte Tabelle zeigt alle möglichen Kombinationen der Schaltstellungen der drei Schalter SA, SB und SC, die dabei von den beiden Decodern 14 und 16 eingenommenen Zustände sowie den dabei aktivierten Ausgang a der Auswahllogik 17. Auch hieraus ist ohne weiteres ersichtlich, dass n-Schaltern, die jeweils drei Zustände einnehmen können, $3^n$ mögliche Zustände realisiert werden können.

Fig. 3 zeigt ein detailiertes Blockschaltbild der Schaltungsanordnung nach Fig. 1.

Zusätzlich zu den in Fig. 1 dargestellten Funktionsblöcken zeigt Fig. 3 eine Ablaufsteuerung 20, die hier fünf Ausgangsleitungen 21 bis 25 hat. Auf diesen Ausgangsleitungen erscheinen zeitlich nacheinander jeweils Steuersignale Φ1 bis Φ5, wodurch der zeitliche Ablauf der einzelnen Funktionen gesteuert wird. Die Ausgangsleitung 21 ist mit einem Rücksetzeingang des Zählers 15 verbunden. Die Ausgangsleitungen 22, 23 und 24 sind jeweils mit einem Steuereingang eines Impulsgebers 26, 27 bzw. 28 verbunden, wobei diese Impulsgeber die beschriebene Anzahl von (negativen) Impulsen TA, TB bzw. TC zu den Schaltern SA, SB bzw. SC liefern. Die Ablauffolge der Signale Φ2, Φ3 und Φ4 ist so, dass zuerst der Impulsgeber 26, dann der Impulsgeber 27 und schliesslich der Impulsgeber 28 ihre vorgegebene Anzahl von Impulsen erzeugen. Auch aus dem Blockschaltbild der Fig. 3 ist erkennbar, dass der erste Decoder 14 im Parallelbetrieb und sozusagen statisch die Zustände der Schalter SA, SB und SC abfragt. Es ist noch darauf hinzuweisen, dass die Impulsgeber 26, 27 und 28 in ihrem "Ruhezustand" eine logische 1 führen, so dass an den

3

Anschlüssen 11, 12 und 13 auch dann eine logische 1 anliegt, wenn die Schalter SA, SB bzw. SC im Schaltzustand "1" oder "2" sind. Weiterhin ist zu erkennen, dass die Ausgangsimpulse der Impulsgeber 26, 27 bzw. 28 nur über solche Schalter zu dem Zähler 15 gelangen, die im Schaltzustand "2" sind.

Zur Ablaufsteuerung 15 ist noch anzumerken, dass die Signale Φ1 bis Φ5 in der Reihenfolge ihrer Nummerierung auftreten, d. h. zuerst wird der Zähler 15 auf 0 zurückgesetzt, dann werden aufeinanderfolgend die Impulsgeber 26, 27 und 28 aktiviert und schliesslich wird über das Signal Φ5 auf der Leitung 25 die Auswahllogik 17 freigegeben. Damit führt die Auswahllogik 17 erst dann ein Ausgangssignal, wenn sicher gestellt ist, dass der Zähler 15 alle ihn betreffenden Impulse gezählt hat. Während der Aktivität der Impulsgeber 26, 27 und 28 ändern sich natürlich auch die Zustände des ersten Decoders 14. Sobald aber die Zählimpulse beendet sind, fragt der Decoder nach Beendigung des Signales Φ4 die Zustände der Schalter SA, SB und SC ab und gibt sie dann an die Auswahllogik 17 in decodierter Form weiter.

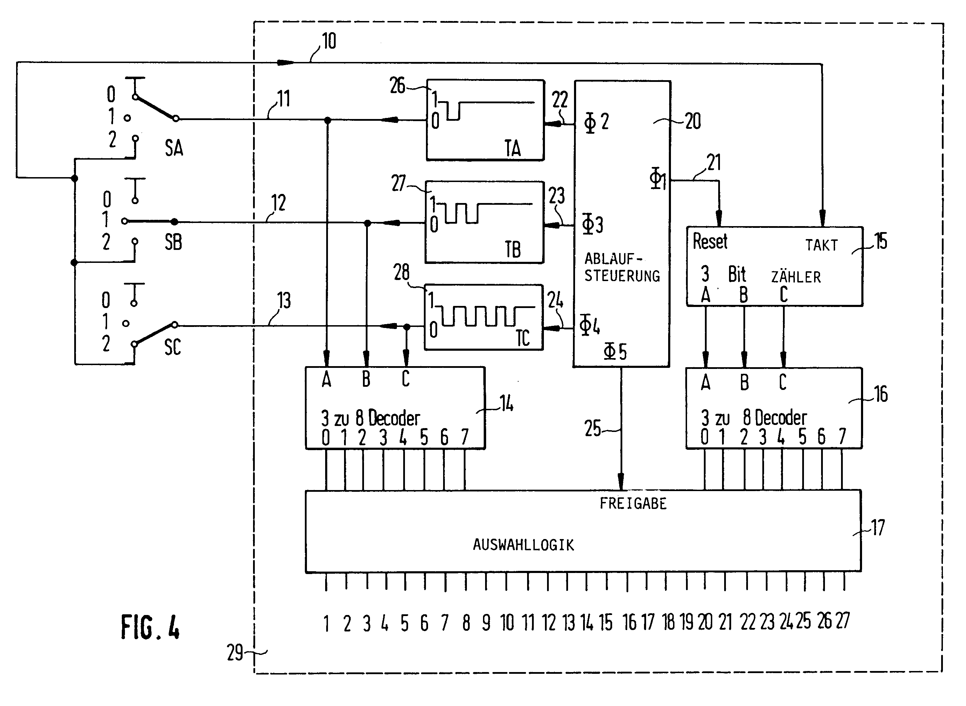

Fig. 4 zeigt im Prinzip das gleiche Blockschaltbild wie Fig. 3, lediglich in etwas geänderter Anordnung. Hiermit soll verdeutlicht werden, dass alle Baugruppen 14 bis 28 innerhalb eines integrierten Schaltkreises angeordnet sind, während lediglich die Schalter SA, SB und SC ausserhalb desselben als "externe Beschaltung" liegen. Die eigentlichen Ansteueranschlüsse sind lediglich die Anschlüsse 11, 12 und 13, während der ebenfalls für die Ansteuerung verwendete Anschluss 10 bei Mikroprozessoren meistens als Takt- bzw. Zähleingang vorhanden ist, so dass für ihn kein zusätzliches Ansteuer-"Beinchen" erforderlich ist. Weiterhin ist aus Fig. 4 deutlicher zu erkennen, dass die binär codierten, parallel anliegenden Signale an den Anschlüssen 11, 12 und 13 extern erzeugt werden und damit dem integrierten Schaltkreis 29 von aussen zugeführt werden, während die zeitlich aufeinander folgenden Impulse intern im integrierten Schaltkreis 29 erzeugt werden, an den Anschlüssen 11, 12 bzw. 13 ausgegeben werden und über die externe Beschaltung (Schalter SA, SB und SC) an den Anschluss 10, der dann als "Eingangs-Anschluss" dient, zurückgegeben werden.

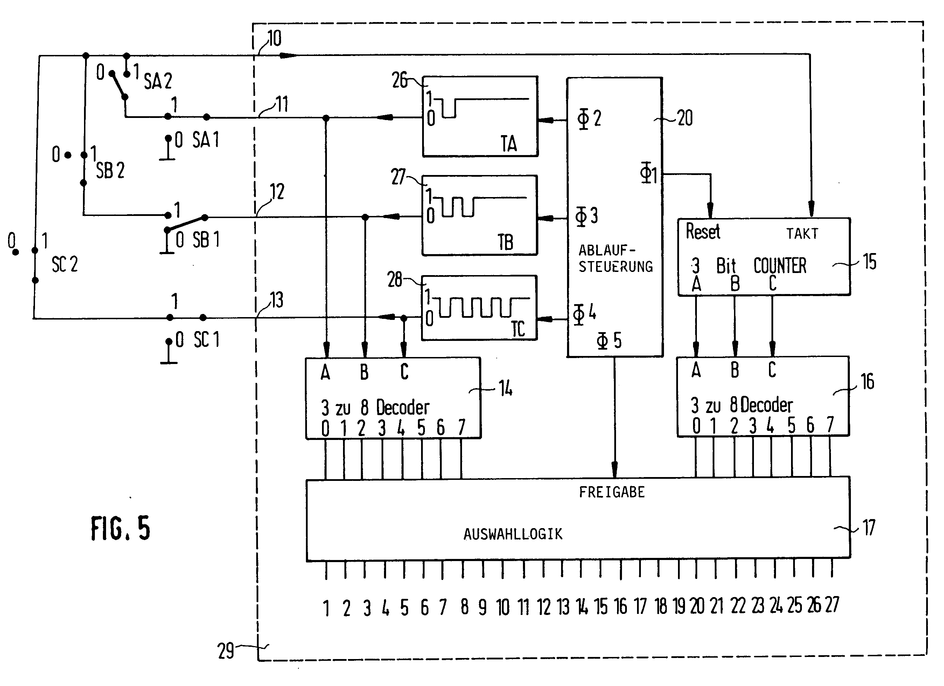

Fig. 5 zeigt eine Modifikation des Blockschaltbildes der Fig. 4. Die im Inneren des integrierten Schaltkreises 29 der Fig. 5 im Zusammenhang mit der Erfindung benötigten Bauteile sind identisch mit denen der Fig. 4.

Lediglich die "externe Beschaltung" der Anschlüsse 10, 11, 12 und 13 wurde geändert. Statt drei Schaltern mit jeweils drei Schaltstellungen werden sechs Schalter mit zwei möglichen Schaltstellungen verwendet. Die Schalter SA, SB und SC der Fig. 4 wurden hier in jeweils zwei Schalter SA1, SA2; SB1, SB2; und SC1, SC2 aufgeteilt, die wirkungsmässig in Reihe geschaltet sind und zwar so, dass der Schaltarm des Schalters mit dem Index 2 an den mit "1" bezeichneten Anschluss des jeweiligen Schalters mit dem Index 1 angeschlossen ist. Die mit einer "0" bezeichneten Anschlüsse der Schalter mit dem Index 1 liegen auf Masse, so dass die Ausgänge der hieran angeschlossenen Impulsgeber 26, 27 bzw. 28 dann kurzgeschlossen sind. Selbst wenn die Ablaufsteuerung 20 einen entsprechenden Impulsgeber aktiviert, gelangen dessen Impulse dann nicht zum Eingang des Zählers 15. Dies ist vielmehr nur über einen solchen der Schalter mit dem Index 1 möglich, der im Zustand "1" steht. Erst dann sind die Schalter mit dem Index 2 hinsichtlich ihrer Schaltstellung für die zum Zähler gelangenden Impulse relevant. Sie lassen die entsprechenden Impulse durch, wenn sie im Schaltzustand "1" sind. Im Schaltzustand "0" gelangen dagegen die Impulse nicht zu dem Anschluss 10. Die Schaltstellung "0" der Schalter SA2, SB2 und SC3 ist eine "offene Schaltstellung". Eine Erdung ist nicht erlaubt, da ansonsten sich unabhängig von der Stellung des zugewandten Schalters mit dem Index 1 der Schaltzustand "0" am entsprechenden Anschluss 11, 12 bzw. 13 einstellen würde. Untersucht man unter Beachtung der obigen Regeln die möglichen erlaubten Schaltstellungen, so ergeben sich bei n Schalterpaaren wiederum 3 mögliche Schaltkombinationen. Diese möglichen Schaltkombinationen sind der nachfolgenden Tabelle zu entnehmen, wobei ein waagerechter Strich invariante Schaltzustände bezeichnet, die keinen Einfluss auf eine mögliche Auswahl haben:

| SC1 | SB1 | SA1 | SC2 | SB2 | SA2 | Auswahl |
|-----|-----|-----|-----|-----|-----|---------|
| O | O | O | - | - | - | O |
| O | O | 1 | - | - | O | 1 |
| O | O | 1 | - | - | 1 | 2 |
| O | 1 | O | - | O | - | 3 |
| O | 1 | O | - | 1 | - | 4 |
| O | 1 | 1 | - | O | O | 5 |
| O | 1 | 1 | - | O | 1 | 6 |
| O | 1 | 1 | - | 1 | O | 7 |
| O | 1 | 1 | - | 1 | 1 | 8 |
| 1 | O | O | O | - | - | 9 |
| 1 | O | O | 1 | - | - | 10 |
| 1 | O | 1 | O | - | O | 11 |
| 1 | O | 1 | O | - | 1 | 12 |
| 1 | O | 1 | 1 | - | O | 13 |
| 1 | O | 1 | 1 | - | 1 | 14 |
| 1 | 1 | O | O | O | - | 15 |
| 1 | 1 | O | O | 1 | - | 16 |
| 1 | 1 | O | 1 | O | - | 17 |
| 1 | 1 | O | 1 | 1 | - | 18 |
| 1 | 1 | 1 | O | O | O | 19 |
| 1 | 1 | 1 | O | O | 1 | 20 |
| 1 | 1 | 1 | O | 1 | O | 21 |
| 1 | 1 | 1 | O | 1 | 1 | 22 |
| 1 | 1 | 1 | 1 | O | O | 23 |
| 1 | 1 | 1 | 1 | O | 1 | 24 |
| 1 | 1 | 1 | 1 | 1 | O | 25 |
| 1 | 1 | 1 | 1 | 1 | 1 | 26 |

Abschliessend sei darauf hingewiesen, dass die Erfindung sowohl zur Eingabe als auch zur Ausgabe von Daten, Befehlen, Schaltzuständen etc. bei integrierten Schaltkreisen anwendbar ist. In den Ausführungsbeispielen der Fig. 1 bis 5 wurde davon ausgegangen, dass die Auswahllogik 17 den weiteren, nicht dargestellten Baugruppen des integrierten Schaltkreises 29 bestimmte Steuerbefehle, Adressen etc. zuführt.

Es ist nun genauso möglich, die Anschlüsse 10, 11, 12 und 13 mit Ausgängen eines integrierten Schaltkreises zu verbinden, der analog zu den Schaltern SA, SB und SC codierte Signale erzeugt, so dass die Schaltungsanordnung nach der Erfindung als Ausgangsdecodierer arbeitet, der dann 3 Ausgänge hat, von denen jeweils nur einer aktiviert ist. Hierbei ist es auch möglich, die Ablaufsteuerung 20 und die Impulsgeneratoren 26, 27 und 28 in den integrierten Schaltkreis zu verlegen, welcher dann n + 3 Ausgänge hat, nämlich die den Ausgängen 22, 23 und 24 der Ablaufsteuerung 20 entsprechenden codierten Ausgänge (Anzahl n), die Steuerausgänge entsprechend den Ausgängen 21 und 25 der Ablaufsteuerung 20 sowie den Zählausgang entsprechend dem Anschluss 10.

**Patentansprüche**

1. Verfahren zum selektiven Ansteuern von elektrischen Schaltkreisen, die eine Anzahl n von Ansteueranschlüssen aufweisen, wobei bei der Ansteuerung an jedem Ansteueranschluß logische Signale (0/1) anliegen, nämlich

a) in einem Binärcode codierte, parallel anliegende Signale (z.B. BCD-Code) und

b) zeitlich aufeinanderfolgende Impulse, wobei nur die an einem ausgewählten Anschluß anstehenden Impulse ausgewertet werden, während beide Arten von Signalen (gemäß a) und b)) zusammen einen Ansteuerzustand definieren,

**dadurch gekennzeichnet**, daß

- die zwei verschieden codierten Arten von Signalen zeitlich aufeinanderfolgend an den Ansteueranschlüssen anliegen,

- an den einzelnen Ansteueranschlüssen eine jeweils verschiedene Anzahl von Impulsen anliegt und

- die Gesamtzahl der ausgewerteten Impulse gezählt wird.

2. Verfahren nach Anspruch 1, dadurch gekennzeichnet, dass zunächst die Impulse nach Merkmal b) und darauffolgend die Signale nach Merkmal a) an den Ansteueranschlüssen anliegen.

3. Verfahren nach Anspruch 1 oder 2, dadurch gekennzeichnet, dass die Impulse nach b) zeitlich zueinander versetzt sind.

4. Verfahren nach einem der Ansprüche 1 bis 3, dadurch gekennzeichnet, dass die Anzahl von Impulsen gemäss Merkmal b) dem Gewicht (z. B. 1, 2, 4, 8, 16) der Stellen eines Binärcodes entspricht.

5. Verfahren nach einem der Ansprüche 1, 2 oder 4, dadurch gekennzeichnet, dass die Impulse gemäss b) einem gemeinsamen, separaten Eingang zugeführt und dort gezählt werden.

6. Verfahren nach einem der Ansprüche 1 bis 5, dadurch gekennzeichnet, dass nur die Impulse an denjenigen Ansteueranschlüssen ausgewertet werden, deren Signale gemäss a) einen festgelegten logischen Zustand (0 oder 1) aufweisen.

7. Schaltungsanordnung zur Durchführung des Verfahrens nach einem der Ansprüche 1 bis 6, mit einem anzusteuernden Schaltkreis, der eine Anzahl n von Ansteueranschlüssen aufweist sowie einem mit diesem verbundenen ersten Decodierer (14), gekennzeichnet durch

- mit den Ansteueranschlüssen (11, 12, 13) verbundene Impulserzeuger (26, 27, 28), die jeweils eine unterschiedliche Anzahl von Impulsen (TA, TB, TC) erzeugen,

- eine mit Steuereingängen (22, 23, 24) der Impulserzeuger (26, 27, 28) verbundene Ablaufsteuerung (20), die die einzelnen Impulserzeuger (26, 27, 28) zeitlich nacheinander decodiert,

- einen Zähler (15), der in Abhängigkeit von logischen Zuständen an den Ansteueranschlüssen (11, 12, 13) ausgewählte Impulse der Impulserzeuger (26, 27, 28) zählt,

- einen dem Zähler (15) nachgeschalteten, zweiten Decoder (16) und

- eine beiden Decodern (14, 16) nachgeschaltete Auswahllogik (17).

8. Schaltungsanordnung nach Anspruch 7, gekennzeichnet durch eine Anzahl n von mit den Ansteueranschlüssen (11, 12, 13) verbundenen Schaltelementen (SA, SB, SC), die jeweils drei verschiedene Schaltstellungen (Schaltstellung 0, 1 bzw. 2) einnehmen, wobei der jeweilige Ansteueranschluss (11, 12, 13) in der Schaltstellung 0 geerdet, in der Schaltstellung 1 potentialfrei und in der Schaltstellung 2 mit einem Zähleingang (10) des Zählers (15) verbunden ist, wobei die Impulserzeuger (26, 27, 28) negative Impulse erzeugen, d. h. in ihrem Ruhezustand eine logische "1" führen.

9. Schaltungsanordnung nach Anspruch 7, gekennzeichnet durch eine Anzahl von 2 n Schaltelementen (SA1, SA2; SB1, SB2; SC1, SC2), die jeweils paarweise in Reihe geschaltet sind und jeweils zwei verschiedene Schaltzustände aufweisen, wobei die in Reihe geschalteten Schalterpaare einerseits mit den Ansteueranschlüssen (11, 12, 13) verbunden sind und andererseits gemeinsam mit dem Zähleingang (10) des Zählers (15).

10. Schaltungsanordnung nach einem der Ansprüche 7 bis 9, dadurch gekennzeichnet, dass die Impulserzeuger (26, 27, 28) jeweils eine Anzahl von Impulsen erzeugen, die dem Gewicht (z. B. 1, 2, 4, 8 16) der Stellen eines Binärcodes entspricht.

11. Schaltungsanordnung nach einem der Ansprüche 7 bis 10, dadurch gekennzeichnet, dass die Ablaufsteuerung (20) zusätzlich Rücksetzsignale ($\Phi 1$) für den Zähler (15) und Freigabesignale ($\Phi 5$) für die

Auswahllogik (17) erzeugt.

**12.** Schaltungsanordnung nach einem der Ansprüche 7 bis 11, dadurch gekennzeichnet, dass die beiden Decoder (14, 16) jeweils "n zu $2^n$"-Decoder sind, die also n Eingangsanschlüsse und $2^n$ Ausgangsanschlüsse aufweisen, wobei bei jeder Signalkombination an den Eingangsanschlüssen nur ein einziger Ausgangsanschluss ein Ausgangssignal führt.

**13.** Schaltungsanordnung nach einem der Ansprüche 7 bis 12, dadurch gekennzeichnet, dass der Zähler (15) ein n-Bit-Binärzähler ist.

**14.** Schaltungsanordnung nach einem der Ansprüche 7 bis 13, dadurch gekennzeichnet, dass die Auswahllogik (17) $3^n$ UND-Gatter (18, 19) aufweist, deren Eingänge je mit einem Ausgang der beiden Decoder (14, 16) verbunden sind, entsprechend den dort möglichen Signalkombinationen.

## Claims

**1.** Process for selectively driving electrical circuits which have a number n of drive connections, logic signals (0/1) being applied across each drive connection on driving, namely
   a) parallel signals in a binary code (e.g. BCD code) and
   b) sequential pulses, only the pulses applied across a selected connection being evaluated, while both types of signals (those of a) and b)) together define a drive state,
characterized in that
   - the two differently coded types of signals are applied sequentially across the drive connections,
   - in each case a different number of pulses is applied across the individual drive connections, and
   - the total number of pulses evaluated is counted.

**2.** Process according to Claim 1, characterized in that first the pulses with feature b) and subsequently the signals with feature a) are applied across the drive connections.

**3.** Process according to Claim 1 or 2, characterized in that the pulses according to b) are out of phase.

**4.** Process according to one of Claims 1 to 3, characterized in that the number of pulses of feature b) corresponds to the weight (e.g. 1, 2, 4, 8, 16) of the digits of a binary code.

**5.** Process according to one of Claims 1, 2 or 4, characterized in that the pulses of b) are supplied to a common separate input and are counted there.

**6.** Process according to one of Claims 1 to 5, characterized in that only the pulses at those drive connections whereof the signals of a) have a fixed logic state (0 or 1) are evaluated.

**7.** Circuit arrangement for carrying out the process according to one of Claims 1 to 6, having a circuit to be driven which has a number n of drive connections, and having a first decoder (14) connected thereto, characterized by
   - pulse generators (26, 27, 28) connected to the drive connections (11, 12, 13) and in each case generating a different number of pulses (TA, TB, TC),
   - a sequencer (20) which is connected to control inputs (22, 23, 24) of the pulse generators (26, 27, 28) and which decodes the individual pulse generators (26, 27, 28) sequentially,
   - a counter (15) which in dependence on logic states at the drive connections (11, 12, 13) counts selected pulses of the pulse generators (26, 27, 28),
   - a second decoder (16) downstream of the counter (15) and
   - a selection logic (17) downstream of both decoders (14, 16).

**8.** Circuit arrangement according to Claim 7, characterized by a number n of switch elements (SA, SB, SC) which are connected to the drive connections (11, 12, 13) and which in each case adopt three different switch positions (switch position 0, 1 and 2 respectively), the respective drive connection (11, 12, 13) being earthed in switch position 0, being isolated in switch position 1 and being connected to a counting input (10) of the counter (15) in switch position 2, with the pulse generators (26, 27, 28) generating negative pulses, that is to say supplying a logic "1" in their rest state.

**9.** Circuit arrangement according to Claim 7, characterized by a number of 2 n switch elements (SA1, SA2; SB1, SB2; SC1, SC2) which are in each case connected in pairs and in series and in each case have two different switch states, the switch pairs connected in series being connected on the one hand to the drive connections (11, 12, 13) and on the other hand jointly to the counting input (10) of the counter (15).

**10.** Circuit arrangement according to one of Claims 7 to 9, characterized in that the pulse generators (26, 27, 28) in each case generate a number of pulses corresponding to the weight (e.g. 1, 2, 4, 8, 16) of the digits of a binary code.

**11.** Circuit arrangement according to one of Claims 7 to 10, characterized in that the sequencer (20) additionally generates reset signals ($\Phi$1) for the counter (15) and release signals ($\Phi$5) for the selection logic (17).

**12.** Circuit arrangement according to one of Claims 7 to 11, characterized in that the two decoders (14, 16) are in each case "n to $2^n$" decoders which thus have n input connections and $2^n$ output connections, in each signal combination at the input connections only a single output connection supplying an output signal.

**13.** Circuit arrangement according to one of Claims 7 to 12, characterized in that the counter (15) is an n-bit binary counter.

**14.** Circuit arrangement according to one of Claims 7 to 13, characterized in that the selection logic (17) has $3^n$ AND gates (18, 19) whereof the inputs are in each case connected to an output of the two decoders (14, 16) corresponding to the signal combinations possible there.

**Revendications**

**1.** Procédé d'activation sélective de circuits électriques présentant un nombre n de bornes d'activation, dans lequel des signaux logiques (0/1) sont présents sur chaque borne d'activation pendant la commande, lesdits signaux étant:
(a) des signaux codés dans un code binaire (par exemple en code BCD) appliqués en parallèle; et
(b) des impulsions qui se suivent en séquence temporelle, dans lequel uniquement les impulsions présentes sur une borne sélectionnée sont prises en compte, tandis que les deux types de signaux [selon a) et b)] définissent ensemble un état d'activation, caractérisé en ce que:
- les deux types de signaux codés différemment sont présents sur les bornes d'activation l'un après l'autre en séquence temporelle,
- sur chacune des bornes individuelles d'activation, est présent un nombre différent d'impulsions, et
- on compte le nombre total d'impulsions qui sont prises en compte.

**2.** Procédé selon la revendication 1, caractérisé en ce que sont présents sur les bornes d'activation, tout d'abord, les impulsions selon la caractéristique b) et ensuite les signaux selon la caractéristique a).

**3.** Procédé selon la revendication 1 ou 2, caractérisé en ce que les impulsions selon b) sont décalées dans le temps l'une par rapport à l'autre.

**4.** Procédé selon l'une des revendications 1 à 3, caractérisé en ce que le nombre d'impulsions selon la caractéristique b) correspond au poids (par exemple 1, 2, 4, 8, 16) des positions d'un code binaire.

**5.** Procédé selon l'une des revendications 1, 2 ou 4, caractérisé en ce que les impulsions selon b) sont adressées à une entrée commune et séparée où elles sont comptées.

**6.** Procédé selon l'une des revendications 1 à 5, caractérisé en ce que l'on prend en compte uniquement les impulsions sur celles des bornes d'activation dont les signaux selon a) présentent un état logique déterminé (0 ou 1).

**7.** Agencement de circuit pour la mise en oeuvre du procédé selon l'une quelconque des revendications 1 à 6, comprenant un circuit à commander par activation qui présente un nombre n de bornes d'activation ainsi qu'un premier décodeur (14) associé à ce circuit, caractérisé par:
- des générateurs d'impulsions (26, 27, 28) reliés aux bornes d'activation (11, 12, 13) et qui, chacun, émettent un nombre d'impulsions (TA, TB, TC) différent;
- un séquenceur (20) raccordé à des entrées de commande (22, 23, 24) des générateurs d'impulsions (26, 27, 28), et qui décode les générateurs individuels d'impulsions (26, 27, 28) l'un après l'autre dans le temps;
- un compteur (15) qui, en fonction des états logiques sur les bornes d'activation (11, 12, 13) compte des impulsions sélectionnées des générateurs d'impulsions (26, 27, 28);
- un deuxième décodeur (16) branché en aval sur le compteur (15); et
- une logique de sélection (17) branchée en aval de deux décodeurs (14, 16).

8. Agencement de circuit selon la revendication 7, caractérisé par un nombre n d'éléments de commutation (SA, SB, SC) reliés aux bornes d'activation (11, 12, 13) qui prennent chacun trois positions différentes de commutation (positions de commutation 0, 1 ou 2) dans lequel la borne d'activation correspondante (11, 12, 13) est mise à la masse pour la position de commutation 0, se trouve sans tension à la position de commutation 1 et est connecté à une entrée de comptage (10) du compteur (15) pour la position de commutation 2 et dans lequel les générateurs d'impulsions (26, 27, 28) émettent des impulsions négatives produisant ainsi un "1" logique à l'état de repos.

9. Agencement de circuit selon la revendication 7, caractérisé par une pluralité de 2 n éléments de commutation (SA1, SA2; SB1, SB2; SC1, SC2) qui sont, dans chaque cas, connectés par paires en série et qui présentent chacun deux états de commutation différents, dans lequel les paires d'éléments de commutation connectés en série sont reliées d'une part aux bornes d'activation (11, 12, 13) et, d'autre part, ensemble à l'entrée de comptage (10) du compteur (15).

10. Agencement de circuit selon l'une des revendications 7 à 9, caractérisé en ce que les générateurs d'impulsions (26, 27, 28) émettent chacun une pluralité d'impulsions qui correspondent aux poids (par exemple 1, 2, 4, 8, 16) des positions d'un code binaire.

11. Agencement de circuit selon l'une des revendications 7 à 10, caractérisé en ce que le séquenceur (20) produit en plus des signaux de remise à zéro ($\Phi$1) pour le compteur (15) et des signaux de validation ($\Phi$5) pour la logique de sélection (17).

12. Agencement de circuit selon l'une des revendications 7 à 11, caractérisé en ce que les deux décodeurs (14, 16) sont chacun des décodeurs "n à $2^n$" qui comportent en conséquence n bornes d'entrée et $2^n$ bornes de sortie, dans lequel, pour chaque combinaison de signaux présents sur les bornes d'entrée, uniquement une seul borne de sortie porte un signal de sortie.

13. Agencement de circuit selon l'une des revendications 7 à 12, caractérisé en ce que le compteur (15) est un compteur binaire à n bits.

14. Agencement de circuit selon l'une des revendications 7 à 13, caractérisé en ce que la logique de sélection (17) est équipée de $3^n$ portes ET (18, 19), dont les entrées sont connectées chacune à une entrée des deux décodeurs (14, 16) en correspondance aux combinaisons de signaux qui y sont possibles.

9

**FIG.1**

**FIG.2**

| SC | SB | SA | S Decoder | Z Decoder | (a) AUSWAHL |
|----|----|----|-----------|-----------|-------------|
| 0 | 0 | 0 | 0 | 0 | 0 |
| 0 | 0 | 1 | 1 | 0 | 1 |
| 0 | 0 | 2 | 1 | 1 | 2 |
| 0 | 1 | 0 | 2 | 0 | 3 |
| 0 | 1 | 1 | 3 | 0 | 4 |
| 0 | 1 | 2 | 3 | 1 | 5 |
| 0 | 2 | 0 | 2 | 2 | 6 |
| 0 | 2 | 1 | 3 | 2 | 7 |
| 0 | 2 | 2 | 3 | 3 | 8 |
| 1 | 0 | 0 | 4 | 0 | 9 |
| 1 | 0 | 1 | 5 | 0 | 10 |
| 1 | 0 | 2 | 5 | 1 | 11 |
| 1 | 1 | 0 | 6 | 0 | 12 |
| 1 | 1 | 1 | 7 | 0 | 13 |
| 1 | 1 | 2 | 7 | 1 | 14 |
| 1 | 2 | 0 | 6 | 2 | 15 |
| 1 | 2 | 1 | 7 | 2 | 16 |
| 1 | 2 | 2 | 7 | 3 | 17 |
| 2 | 0 | 0 | 4 | 4 | 18 |
| 2 | 0 | 1 | 5 | 4 | 19 |
| 2 | 0 | 2 | 5 | 5 | 20 |
| 2 | 1 | 0 | 6 | 4 | 21 |
| 2 | 1 | 1 | 7 | 4 | 22 |
| 2 | 1 | 2 | 7 | 5 | 23 |
| 2 | 2 | 0 | 6 | 6 | 24 |
| 2 | 2 | 1 | 7 | 6 | 25 |
| 2 | 2 | 2 | 7 | 7 | 26 |

FIG. 3

EP 0 202 684 B1

FIG. 4

EP 0 202 684 B1

**FIG. 5**